# EUROPEAN PATENT APPLICATION

(11) **EP 3 276 420 A1**
(43) Date of publication of application: **31.01.2018**
(21) Application number: 17182703.3
(22) Date of filing: 22.07.2017
(51) Int. Cl.: G03F 7/40

(54) **METHOD FOR PLATING ON THE SURFACE OF NON-CONDUCTIVE SUBSTRATE**

(30) Priority: 29.07.2016 JP 2016150032
(71) Applicant: Rohm and Haas Electronic Materials LLC, Marlborough, MA 01752 (US)
(72) Inventor: OKADA, Hiroki, Agano-shi, Niigata 959-1914 (JP); LI, Shenghua, Agano-shi, Niigata 959-1914 (JP); HAGA, Mitsuru, Agano-shi, Niigata 959-1914 (JP)
(74) Representative: Houghton, Mark Phillip

(57) **Abstract**

A method for forming a metal layer with selectively high adhesion on a desired section(s) on a non-conductive substrate without etching a surface of the non-conductive substrate is disclosed. The method involves applying a specific photosensitive resin composition onto a non-conductive substrate to form a resin layer in a desired section(s) of the non-conductive substrate by exposure and development, and then, to perform pretreatment with an alkaline solution.

## Description

### Filed of the Invention

The present invention relates to a method for forming a metal layer onto a non-conductive substrate surface. More specifically, the present invention relates to a method for forming a metal layer with selectively high adhesion on a desired section(s) on a non-conductive substrate surface without etching the non-conductive substrate surface.

### Background of the Invention

As a method for forming a metal layer on a desired section(s) on a non-conductive substrate surface, such as resin (method for forming a metal pattern), "subtractive method", "semi-additive method" and "full-additive method" are mainly known.

The subtractive method is a method where a photosensitive layer that is insolubilized in a developing fluid by light irradiation, or that is solubilized into a developing fluid due to light irradiation is placed on a metal layer formed on a substrate; this photosensitive layer is exposed via a pattern mask; this is developed with a developing fluid; a resist layer (resist pattern) is formed on a region where a metal pattern should be formed; subsequently, metal in the region that is not covered with the resist layer is removed by etching; and then, the resist pattern is peeled off and only the metal pattern remains on the substrate. With this method, metal etching for the purpose of removal of unnecessary sections by etching becomes required after the metal layer is formed over the entire surface of the substrate, and a waste occurs in the metal in use. In addition, since the adhesion between the substrate and the metal layer is poor, resin etching for the purpose of making the substrate surface uneven is normally applied, and it is necessary to enhance the adhesion between the substrate and the metal layer by a so-called anchor effect. However, in order to apply the resin etching, a chemical with a high environmental burden, such as chromic acid, has to be used, and there is a point at issue that its liquid waste disposal requires cost burden and great care.

In order to solve this problem, a method for forming a metal pattern referred to as a semi-additive method is proposed. The semi-additive method is a method where a thin metallic underlying metal layer is formed on a substrate by plating or the like; and a resist pattern is formed on the underlying metal layer as similar to above. Subsequently, after metal, such as copper, is precipitated by plating on the underlying metal layer on a region other than the region where the resist pattern has been formed and a metal layer is formed, a metal pattern is formed by removing the resist pattern. Subsequently, the underlying metal layer on a section where no metal pattern is formed using the metal pattern as a mask is removed by etching, and only the metal pattern is left on the substrate. Even with this method, metal etching for the purpose of removal of the underlying metal layer is required, and it is also necessary to perform resin etching that makes the substrate surface uneven in order to enhance the adhesion between the substrate and the metal layer, and this method has a similar point at issue to that in the case of the subtractive method.

Further, a method for forming a metal pattern referred to as a full-additive method is also proposed. With the full-additive method, a resist pattern is formed on a substrate, metal is plated normally by non-electrolytic plating in a region other than the resist pattern, and then, the resist pattern is removed. A substrate that is used in this method also requires the resin etching to make the substrate surface uneven in order to enhance the adhesion between the substrate and the metal layer, and this method also has the similar point at issue to that in the case of the subtractive method. Therefore, a new metal pattern forming method where a metal plating layer with high adhesion can be formed without any resin etching on the substrate surface is in demand.

In Japanese Patent Application Laid-open No. 2005-347423, a metal pattern formation method having steps to form a region where a graft polymer having a functional group that is directly coupled with the substrate surface, and, that interacts with an electroless plating catalyst, on the surface of a polyimide substrate having a specific chemical structure in a pattern manner; to provide the electroless catalyst to the region; and to form a pattern-state metal film by electroless plating is disclosed, but it is necessary to use a polyimide substrate having a specific structure and a specific graft polymer, and this method cannot be applied to extensive substrates.

In Japanese Patent Application Laid-open No. 2010-31318, a method for forming a metal film where a primer layer is formed on a substrate; an undercoating containing a reducing polymer microparticle and a binder is applied on the primer layer; and a metal film is formed on the undercoating by electroless plating is disclosed, but because two layers, the primer layer and the undercoating layer, have to be formed on the substrate, this is complicated, and the formation of a metal pattern is not mentioned.

In the meantime, in Japanese Patent Application Laid-open No. 2013-209643, a method for forming a conductive wiring pattern by applying a composition containing a composite body of palladium particles and a dispersant onto a electroless substrate using a pattern printing technology, such as inkjet, and by electroless plating is disclosed, but the palladium particles that become engaged in the reaction as a electroless plating catalyst exist only in the superficial layer of the composite body and its majority cannot become engaged in the reaction, and this method is not preferable from a viewpoint of manufacturing cost.

In Japanese Patent Application Laid-open No. 2008-050541, a method where a molecular adhesive made from a thiol reactive alkoxy silane compound with a specific chemical structure is applied to a resin substrate and a chemical bond with an OH group is formed on the resin substrate surface; subsequently, only a thiol group in the molecular adhesive in the exposure part is chemically reacted with a disulfide group by exposing the applied surface via a mask; and then, a metal pattern is formed only in an unexposed portion by catalyzer forming and electroless plating is described, but a special device for exposing an OH group on the substrate surface by utilizing plasma or ozone, and the exposed OH group by these means is decreased with time; thus, it becomes difficult to control the concentration of solidifying silane compound.

### Summary of the Invention

Therefore, the objective of the present invention is to provide a simple lean method with suppressed manufacturing cost where a metal layer with selectively high adhesion can be formed on a desired section(s) on an electroless substrate without etching a non-conductive substrate surface.

The present inventors, as a result of keen examination, discovered that a metal layer with selectively high adhesion can be formed on a desired section(s) without etching a non-conductive substrate surface by forming a photosensitive film on a specific section(s) on a non-conductive substrate surface using a photosensitive composition containing a reactive polymer and a polymerization initiator, and by treatment using a specific alkaline pretreatment liquid after this photosensitive film layer is thermally treated, and completed the present invention.

In other words, the present invention is a method for forming a metal layer on a non-conductive substrate, and is characterized by including steps (a) to form a photosensitive film by applying a photosensitive film onto a non-conductive substrate, (b) to expose at least a portion of the photosensitive film and to solidify an exposed portion of the photosensitive film, (c) to have the substrate make contact with an alkaline developing fluid and to remove an unexposed portion of the photosensitive film; (d) to thermally heat the substrate; (e) to have the substrate make contact with an alkaline pre-treatment liquid; (f) to have the substrate make contact with a catalyst solution and to provide the catalyst to the pre-treated exposed portion; and then, (g) to perform electroless metal plating on the exposed portion of the photosensitive film on the substrate.

A photosensitive film has a characteristic to be developed with an alkaline developing liquid, and is formed with a photosensitive composition containing a reactive polymer and a polymerization initiator. As long as the characteristic to be developed with an alkaline developing liquid can be provided to a photosensitive film, any reactive polymer and polymerization initiator can be used. In one mode of the present invention, the photosensitive composition can contain a reactive polymer containing an ethylene unsaturated bond group, and, at least one group to be selected from a carboxyl group and a sulfo group, and a polymerization initiator.

The alkaline pre-treatment liquid is an arbitrary alkaline liquid. An alkaline solution is preferable, and preferably contains alkaline metal hydroxide or organic amine.

### Brief Description of the Drawings

Figure 1 is a microscope photograph where a test substrate, where a metal layer is formed, is cut in Example 1 and its cross section was observed with an electronic microscope.
Figure 2 is a metal microscope photograph of a metal layer before an adhesion test in Example 7.
Figure 3 is a metal microscope photograph of a metal layer after an adhesion test in Example 7.
Figure 4 is a metal microscope photograph of a metal layer before an adhesion test in Example 8.
Figure 5 is a metal microscope photograph of a metal layer after an adhesion test in Example 8.
Figure 6 is a metal microscope photograph of a metal layer before an adhesion test in Example 9.
Figure 7 is a metal microscope photograph of a metal layer after an adhesion test in Example 9.
Figure 8 is a metal microscope photograph of a nickel metal layer obtained in Example 10 after an adhesion test.

### Detailed Description of the Invention

In the present specification, °C means a temperature in Celsius, g/L means gram per litter, mg/L means milligram per litter, µm means micrometer, DI means de-ionized, "ppt." means precipitated. Further, percentage (%) means % by weight unless otherwise stated herein. In the present specification, the term "(meth)acrylic" includes acrylic or methacrylic, or both of these. The term "PTL" means pretreatment liquid. The term "ConPTL" means concentration of pretreatment liquid. The term "App" means appearance. The term "Adh" means adhesion.

The method of the present invention is to form a metal layer with high adhesion on a non-conductive substrate surface without etching a non-conductive substrate surface by conducting the steps (a) to (g) in order. Each step is described in order hereafter.

The step (a) is a step to apply a photosensitive composition onto a non-conductive substrate, and to form a photosensitive film. A material constituting the non-conductive substrate is not particularly specified, but for example, a resin and ceramics are exemplified, and as examples of the resin, polyester resin, such as polyethylene terephthalate, polybutylene terephthalate or polylactate ester; acrylic resin, such as polymethylmethacrylate; polycarbonate resin, polystyrene resin, polyvinyl chloride resin, polyamide resin, polyimide resin, polyetherimide resin, polyacetal resin, polyether ether ketone resin, cyclic polyolefin resin, polyethylene resin, polyphenylene sulfide, liquid crystal polymer, modified polyphenyl ether resin, polysulfone resin and phenol resin are exemplified. Further, as examples of ceramics; glass, alumina and the like are exemplified. Shape of the non-conductive substrate is not particularly limited, but for example, a sheet-state and a film-state are exemplified. Further, substrates with various shapes obtained by injection molding or the like can be used.

The photosensitive composition used in the present invention should be ones that contain a reactive polymer and a polymerization initiator, and provide a characteristic to be developed with an alkaline developing liquid to a photosensitive film, and commercial photosensitive compositions can also be used. The photosensitive composition used in the present invention can contain a stabilizer, a cross-linking agent, a solvent, an adhesion enhancer, a sensitizer and the like as needed.

As long as the characteristic to be developed with an alkaline developing fluid can be provided to a photosensitive film, any reactive polymer can be used. As the reactive polymer, for example, polymers where an ethylene unsaturated double bond is introduced into (meth)acrylic resin, polymers where an ethylene unsaturated double bond is introduced into a portion of a polysiloxane resin, and polymers using an oxygen-containing lipid ring, such as epoxy group or oxetane group; an isocyanate group, an alkoxy group or the like instead of an ethylene unsaturated double bond, are exemplified. It is preferable that the reactive polymer used in the present invention contains an ethylene unsaturated bond group, and, at least one group to be selected from a carboxyl group and a sulfo group. In particular, a polymer that contains a monomer containing an acrylic acid and/or a methacrylic acid as a polymerization unit, and that has an ethylene unsaturated double bond is preferable. Such polymer can be obtained by reacting an epoxy compound having an ethylene unsaturated double bond, such as glycidyl methacrylate (GMA), with the obtained polymer in the presence of catalyzer using a monomer containing an acrylic acid and/or a methacrylic acid as a raw material, and by introducing the ethylene unsaturated double bond into the structure. In the case of using GMA, a glycidyl ring in GMA reacts with a portion of a carboxyl group in the polymer obtained from the monomer containing a (meth)acrylic acid, and the ethylene unsaturated bond group can be introduced into the reactive polymer. The polymer that is reacted with GMA can be obtained by co-polymerizing various monomers in addition to an acrylic acid and/or a methacrylic acid, and for example, a polymer that is obtained by co-polymerizing alkyl ester of (meth)acrylic acid or an inactive monomer, such as aromatic ester, maleimides or stylene, and hydroxide, such as alkylester hydroxide or stylene hydroxide, or the like with acrylic acid and or methacrylic acid is exemplified. A preferable ratio of a monomer of the co-polymer to be a basis on the occasion of preparing such polymer is 10/90 to 90/10 at a molar ratio of (meth)acylic acid/ other monomers, and is further preferably 20/80 to 60/40. In addition, 10 to 40 parts by weight of GMA should be reacted per 100 parts by weight of a base co-polymer using an appropriate amount of a basic catalyst.

The reactive polymer having, for example, 10 to 200 mg KOH of acid number, preferably 50 to 150 mg KOH of acid number can be used. The acid number is a value measured by neutralizing titration of potassium hydroxide. A molecular weight (weight-average molecular weight) of the reactive polymer is normally 5,000 to 30,000, preferably 8,000 to 20,000. Furthermore, the weight-average molecular weight is a GPC measurement value in the case of using polystyrene as a target substance.

The content of the reactive polymer is 10 to 90 parts by weight, preferably 30 to 70 parts by weight on the basis of 100 parts by weight of solid content of the photosensitive composition.

In the present invention, any polymerization initiator can be used. As the polymerization initiator, a photopolymerization initiator that initiates polymerization by a light is preferable, and a photo-radical generator (photo-radical photopolymerization initiator) and a photoacid generator can be obtained. A well-known photopolymerization initiator can be used. As examples of the photopolymerization initiator, for example, an imidazole-series compound, a benzoin-series compound, an acetophenone-series compound, an oxime ester-series compound, a benzophenone-series compound, an α-diketone-series compound, a polynuclear quinone-series compound, a xanthone-series compound, a phosphine-series compound, a triazine-series compound and the like can be exemplified. Among these, the acetophenone-series compound and the oxime ester-series compound are preferable. The polymerization initiator can be used singularly or in combination with multiple ones.

As the acetophenone-series compound, for example, an α-hydroxy acetophenone-series compound, an α-amino acetophenone compound and the like can be exemplified, but compounds other than these are also usable. As specific examples of the α-hydroxy acetophenone-series compounds, 1-hydroxycyclohexyl phenyl ketone, 2-hydroxy-2-methylphenyl-propane-1-one and the like can be exemplified, and as specific examples of α-amino acetophenone-series compound, 2-benzyl-2-dimethylamino-1-(4-morpholinophenyl)-butanone, 1,2-dimethylamino-2-(4-methyl-benzyl)-1-(4-morpholine-4-yl-phenyl)-butane-1-one and the like can be exemplified. As specific examples of the oxime ester-series compound, 1,2-octanedion, 1-[4-(phenylthio)phenyl-,2-(O-benzoyloxime)], ethanone, 1-[9-ethyl-6-(2-methylbenzoyl)-9H-carbazole-3-yl]-,1-(O-acetyloxime) and the like can be exemplified. The content of the polymerization initiator is normally 0.1 to 20 parts by weight, and preferably 1 to 10 parts by weight on the basis of 100 parts by weight of solid content of the photosensitive composition.

The stabilizer is also referred to as a reaction control agent, and fulfills a role as a radical scavenger in the photosensitive film prepared from a photosensitive composition. When a photo-radical polymerization initiator is used as a polymerization initiator, if a photosensitive film is exposed, the photo-radical polymerization initiator in the film generates a radical, but this radical tends to be inactivated by oxygen in the vicinity of the film. If a stabilizer is present, because variation of radical generation in the photosensitive film becomes smaller, a preferable hardened material can be obtained. Any stabilizer can be used, but a free-radical stabilizer is preferable. As the free-radical stabilizer, hindered amine or a hindered amine-series derivative(s), a hydroxyphenyl compound and its derivatives and the like are exemplified. The content of the stabilizer is 0.001 to 5.0 parts by weight, and preferably 0.05 parts to 1.0 part by weight on the basis of 100 parts by weight of solid content of the photosensitive composition.

In the present invention, any cross-linking agent can be used. As a compound that can be used as a cross-linking agent, for example, a polymerizable compound having at least two ethylene unsaturated double bonds is exemplified, and multifunctional acrylic acid or methacrylic ester is preferable. As bifunctional (meth)acrylate, as commercial products, for example, ARONIX M-203S and ARONIX M-215 (manufactured by TOA GOSEI Co., Ltd.), KAYARA R-603 and KAYARA FM-400 (manufactured by Nippon Kayaku Co., Ltd.), Light Ester DCP-A (manufactured by KYOEISHA CHEMICAL Co., Ltd.) and the like can be exemplified. Further, as trifunctional or greater (meth)acrylate, as commercial products, for example, ARONIX M-403, M-510, M-8030, ARONIX M-8060 (manufactured by TOA GOSEI Co., Ltd.), KAYARAD TMPTA, KAYARAD DPHA, KAYARAD FM-700 (manufactured by Nippon Kayaku Co., Ltd.), Light Acrylate PE-3A and Light Acrylate DPE-6A (manufactured by KYOEISHA CHEMICAL Co., Ltd.) and the like can be exemplified. The content of the cross-linking agent is normally 20 to 80 parts by weight, and is preferably 30 to 70 parts by weight on the basis of 100 parts by weight of solid content of the photosensitive composition.

A method for applying a photosensitive composition onto a non-conductive substrate is not particularly limited, but for example, spin-coating, roll-coating, spraying, dipping, inkjet, screen printing and the like are exemplified. A drying step is for the purpose of removal of a solvent in the photosensitive composition, and conditions can be set with consideration for a type of substrate, a solvent in the photosensitive composition, a type of other compositions and the like. Further, pre-baking can be conducted after drying or at the same time of drying. The drying conditions depend upon types of substrate and solvent and the like, and for example, drying can be heated on a hot plate or in a drier by heating at 50 °C to 120 °C for 1 minute to 1 hour, preferably at 80 °C to 100 °C for 1 minute to 1 hour. Thickness of the photosensitive film can be 0.1 µm to 1.5 µm, and can be preferably 0.3 µm to 0.8 µm.

The step (b) is a step to expose at least a portion of the photosensitive film and to solidify the exposed portion of the photosensitive film. In order to selectively expose a desired section(s) of the non-conductive substrate, a light is normally irradiated via a mask. The exposure can be conducted, for example, within 10 to 1,000 mJ/cm² of accumulated amount of exposure of a line-i using a light source containing at least a line-i (wavelength 365 nm). With the present step, for example, an ethylene unsaturated bond group, a cross-linking agent and the like in the photosensitive film existing in the exposure section are cross-linked, and the exposed portion is solidified.

The step (c) is a development process, and is a step to have a substrate make contact with an alkaline developing fluid and to remove an unexposed portion of the photosensitive film, and to form a relief image of the photosensitive film. Any alkaline developing fluid can be used, and for example, alkali solutions based mainly on a TMAH solution in the case of an organic system, and alkali solutions based mainly on a potassium hydroxide, sodium hydroxide, sodium hydrogen carbonate or the like in the case of an inorganic system can be exemplified. Conditions on the occasion of having these alkali solutions make contact with a substrate (a type of alkali solution, concentration, a contact time and temperature) vary depending upon a type and thickness of the photosensitive film, and conditions where an unexposed portion of the photosensitive film is removed but an exposed portion remains on the substrate should be appropriately selected. For example, in the case of using a photosensitive composition containing a reactive polymer obtained by reacting GMA with (meth)acrylic-series polymer, it is preferable to make contact between the substrate and the alkaline developing fluid at room temperature for 40 seconds to 180 seconds, and as the alkali solution, concentration of the alkali solution in the case of using potassium hydroxide as the alkali solution is preferably 0.05 % to 1.5 % by weight. As described above, the photosensitive film is dissolved by leaving the exposed portion with the development in the step (c), and the photosensitive film in the exposed portion remains on the non-conductive substrate as a relief image.

The step (d) is a hard-bake process to thermally treat the substrate after developing. Conditions for the thermal treatment vary depending upon a type of the photosensitive film, and for example, the heating temperature is 50 °C to 230 °C, preferably 80 °C to 150 °C, and the heating time is 10 seconds to 2 hours, preferably 5 minutes to 1 hour. With this step, it is believed that the adhesion between the substrate and the relief image is enhanced, and, denseness of the relief image is enhanced.

Step (e) is a step to have the substrate make contact with an alkaline pre-treatment liquid. The alkaline pre-treatment liquid is any alkaline liquid, and for example, it is a solution containing a compound that alkalifies a solution, such as a hydroxide of an alkali metal. As examples of such compound, hydroxide of alkali metal, such as sodium hydroxide or potassium hydroxide; carbonate of alkali metal, such as sodium carbonate, potassium carbonate, sodium hydrogen carbonate or potassium hydrogen carbonate; ammonia; organic amine, such as primary amine including ethylamine, n-propylamine and n-butylamine, secondary amine including diethylamine, di-n- propylamine, di-n-butylamine, tertiary amine including triethylamine, tri-n-propylamine, tri-n-butylamine, alkanolamine including 2-aminoethanol and N,N-dimethyl-2-aminoethanol, or quaternary ammonium including tetramethyl ammonium hydroxide and tetraethyl ammonium hydroxide, can be exemplified. The alkali pre-treatment liquid preferably contains hydroxide of alkali metal or organic amine. The present inventors discovered that fine unevenness is formed on a surface of the relief image obtained up to the previous step by having the substrate having the relief image make contact with this alkali pre-treatment liquid; the adhesion between the surface of the relief image (i.e., a photosensitive film) and the metal layer can be enhanced, and, a moisture retaining group, such as a carboxyl group or a sulfo group, in the vicinity of the relief image surface is exposed to the surface and a catalyst attachment quantity in the next step (f) can be increased. Its mechanism should not be restricted by the above theory, but it is believed that unevenness is formed on the surface of the relief image by dissolving and removing a small amount of low-molecular compound (such as an unreacted monomer(s) existing in the photosensitive composition as impurities or an insufficiently cross-linked cross-linking agent) with the alkali pre-treatment liquid. Further, the moisture retaining group has characteristics to retain moisture, and to enable swelling of the photosensitive film forming the relief image, and since the swelling capability of the moisture retaining group, such as carboxyl group or a sulfo group, that is present in the vicinity of the relief image surface is enhanced due to the alkali pre-treatment liquid in this step, it is believed that the moisture retaining group is exposed on the surface, and a catalyst supporting capability in the next step (f) is enhanced and it advantageously functions for film formation.

Furthermore, a portion of the low-molecular compound, such as the unreacted monomer(s) existing in the vicinity of the relief image surface, can be removed on the occasion of development with the alkali developing fluid in the step (c), but the unevenness of the surface tends to be decreased on the occasion of densifying the relief image in the thermal treatment in the step (d) thereafter. Further, the number of carboxyl groups and the like in the vicinity of the surface of the relief image tends to be decreased by heating in the step (d). Consequently, the treatment with the alkali pre-treatment liquid in this step is effective.

The content of the hydroxide of alkali metal or organic amine varies depending upon a type of the alkali pre-treatment liquid to be used, and for example, in the case of using sodium hydroxide, the content is 0.02 normal (N) or greater, preferably 0.2 to 3 N. Particularly sodium hydroxide solution with 12 or greater of pH is preferable. Even in the case of using another alkali pre-treatment liquid, pH of the alkali pre-treatment liquid is at least 8 or greater, and preferably 10 or greater, further preferably 11 or greater and particularly preferably 12 or greater. Further, in order to remove a low-molecule compound, which was not able to be removed in the development in the step (c), for the alkali pre-treatment liquid in this step, it is preferable to use an alkali solution with a composition, which is different from that used in the step (c), or an alkali solution with higher normality than that used in the step (c) or an alkali solution with higher pH.

The alkali pre-treatment liquid can contain a surfactant, an organic acid, an organic solvent and the like in addition to the compound and the like mentioned above.

The contact between the substrate and the alkali pre-treatment liquid can be performed at any temperature and for any time period, and for example, it can be conducted at 10 °C to 90 °C for 0.5 minutes to 20 minutes, preferably at 20 °C to 70 °C for 1 minute to 10 minutes.

The step (f) is a step to have the substrate make contact with a catalyst solution. For the catalyst solution, any catalysts that are used by a person having ordinary skill in the art, such as tin/ palladium colloid catalyst, is usable. For example, CATAPOSIT™ 44 and CATAPOSIT™ 404 catalysts obtained from Rohm and Haas Electronic Materials K.K. can be exemplified. Further, other than the tin/ palladium colloid, a solution of metallic salt, a solution where metal is stabilized with a complexing agent or the like can be used as a catalyst solution. There is no restriction in metals that can be used, and for example, palladium, copper, silver, gold, nickel, platinum, ruthenium, rhodium, osmium and iridium can be exemplified. Among these, palladium and silver are preferable.

The content of the metal in the catalyst solution varies depending upon the catalyst to be used, and for example, if a palladium salt solution is used as a catalyst, the content is preferably 0.001 to 1 g/L, is further preferably 0.01 to 0.2 g/L on the basis of an entire quantity of the catalyst solution.

The contact between the substrate and the catalyst solution can be performed with any method, and this is performed by having the substrate make contact with a catalyst solution adjusted, for example, at 5 °C to 80 °C, preferably 20 °C to 60 °C, for 0.5 to 20 minutes, preferably for 2 to 5 minutes. Subsequently, the substrate is rinsed with deionized water, and makes contact with a reducing agent solution. For the reducing agent, sodium hypophosphite, formaldehyde, stannous chloride, dimethylamine borane, lithium aluminum hydride, lithium borohydride, sodium boron hydride and the like can be used. The content of the reducing agent in the reducing agent solution varies depending upon a type of the reducing agent to be used, and for example, in the case of using sodium hypophosphite, the content is 20 g/L to 100 g/L. Then, this is rinsed with deionized water as needed.

The step (g) is a step where the photosensitive film on the substrate is electroless-metal-plated. There is no particular restriction in the metal type used in the electroless metal plating, and for example, copper, nickel, gold, palladium, silver, cobalt, zinc or alloys thereof can be exemplified. That electroless metal plating can be performed by immersing the substrate after making contact with the catalyst solution in a commercial electroless metal plating liquid or the like. In the case of performing copper plating as the electroless metal plating, a known electroless copper plating liquid, such as CuPosit™ 328 (manufactured by Rohm and Haas Electronic Materials K.K.), can be used. In the case of performing nickel plating as the electroless metal plating, a known electroless nickel plating liquid, such as NiPosit™ LT (manufactured by Rohm and Haas Electronic Materials K.K.), can be used. There is no particular restriction in the contact conditions between the substrate and the electroless metal plating liquid, and for example, in the case of using a electroless copper plating liquid, this is performed by having the substrate make contact with the electroless copper plating liquid adjusted at 5 °C to 90 °C, preferably at 20 °C to 70 °C, for 0.5 minutes to 60 minutes, preferably for 1 minute to 10 minutes. After that, it can be rinsed with deionized water or the like as needed.

Hereafter, the present invention is explained based upon examples, but these examples shall not limit the scope of the present invention.

### Test substrate:

A polyester film (LUMIRROR™) (29.7 cm long, 21 cm wide and 0.075 mm thick) manufactured by TORAY Industries, Inc., which is a non-conductive substrate, was used.

The process is shown in Table 1, and the composition of the photosensitive composition used in Example 1 is shown in Table 2.

**Table 1**

| Step | Treatment | Compound in use | Condition |
|---|---|---|---|
| (a) | Formation of photosensitive film | Photosensitive composition - 1 | Spin-coating 992 rpm, 30 sec, room temperature |
| | Pre-bake | | 90 °C, 5 min |
| (b) | Exposure | UV | 80 mJ/cm² |
| (c) | Development | 2.38 % TMAH | Room temperature, 1 min |
| | Rinsing with water | Deionized water | Room temperature, 2 min |
| (d) | Hard bake | | 120 °C, 30 min |
| (e) | Treatment with alkali pre-treatment liquid | 1N NaOH | 45 °C, 5 min |
| | Rinsing with water | Deionized water | Room temperature, 2 min. |
| (f) | Catalyst forming | 1.5 % OMNI SHIELD 1573 | 45 °C, 5 min |
| | Rinsing with water | Deionized water | Room temperature, 1 min |
| | Treatment with catalytic reduction | 0.8 % CIRCUPOSIT PB OXIDE CONVERTER 60C | 30 °C, 5 min. |
| | Rinsing with water | Deionized water | Room temperature, 1 min |
| (g) | Electroless copper plating | CUPOSIT 71HS | 58 °C, 5 min |
| | Annealing | | 120 °C, 30 min |

**Table 2**

| Composition | Parts by weight |
|---|---|
| Reactive polymer-1 | 26.72 |
| DPHA | 3.99 |
| M-520 | 3.99 |
| IRGACURE-379 | 0.27 |
| OXE-01 | 0.62 |
| 4H-TEMPO | 0.04 |
| KBM-403 | 1.33 |
| PGMEA | 63.04 |

The reactive polymer-1 in Table 2 is a polymer where 10 parts by weight of high-purity GMA (Blemmer GS (manufactured by NOF Corporation)) has been addition-reacted with a polymer composed of 62 parts by weight of methyl methacrylate, 20 parts by weight of methacrylic acid and 18 parts by weight of benzyl methacrylate as similarly to a method described in the example of Japanese Patent Application Laid-Open No. 2004-107401. The acid number of the reactive polymer-1 was 78 mgKOH/g, and solid content was 36.5 %.

Other compounds are as follows:
RGACURE-379: [manufactured by BASF, 2-dimethylamino-2-(4-methyl-benzyl)-1-(4-morpholine-4-yl-phenyl)-butane-1-one]
OXE-1: IRGACURE OXE-01 [manufactured by BASF, 1,2-octanedion,1-[4-(phenylthio)phenyl-,2-(O-benzoyloxime)]]
DPHA: KAYARAD DPHA [manufactured by Nippon Kayaku Co., Ltd., di-pentaerythritol hexaacrylate]
M-520: Aronix M-520 polybasic acid modified acrylic oligomer (manufactured by TOA GOSEI Co., Ltd.)
4H-TEMPO: 4-hydroxy-TEMPO [manufactured by Wako Pure Chemical Industries, Ltd., 4H-TEMPO (4-hydroxy-2,2,6,6-tetramethylpiperidine-N-oxyl)]
KBM-403: manufactured by Shin-Etsu Chemical Co., Ltd.
PGMEA: propylene glycol monomethylether acetate

### Example 1:

A reactive composition-1 (containing acrylic reactive polymer) was used as a reactive polymer, and application onto a test substrate was conducted using a spin-coater (D-SPIN SK-W60A-AVP, manufactured by SOKUDO Co., Ltd.), and pre-baking was conducted by using a convection oven at 90 °C for 5 minutes, and a photosensitive film was formed. Film thickness of the photosensitive film after pre-baking was 1 micron. Subsequently, exposure was performed using an ultraviolet ray exposure apparatus (MA-1200, manufactured by Japan Science Engineering Co., Ltd.). A high-pressure mercury lamp was used as a light source, and an exposure time was adjusted so as to adjust 80 mJ/cm² of accumulated amount of exposure. For exposure energy, wavelength of a line-i (365 nm) was measured using an illuminometer attached with an ultraviolet exposure meter (UV-M03A, manufactured by ORC Manufacturing Co., Ltd.) and an ultraviolet ray receiver (UV-SN35, manufactured by ORC Manufacturing Co., Ltd.). Subsequently, a substrate after the exposure treatment was immersed into a tetramethylammonium hydroxide (TMAH) solution adjusted to 2.38 % by weight under conditions at room temperature for 1 minute, and development was conducted. After the development, the substrate was rinsed with deionized water for 2 minutes, and was heated for 30 minutes (hard bake) using a convection clean oven (DT-410, Yamato Scientific Co., Ltd.) heated at 120 °C. After that, the test substrate was immersed into a 1N sodium hydroxide solution at 45 °C for 5 minutes. The substrate was rinsed with deionized water at room temperature for 1 minute, and was immersed into a catalyst solution (Omnishield 1573, manufactured by Rohm and Haas Electronic Materials K.K.) at 45 °C for 5 minutes. This catalyst solution contains palladium. Subsequently, rinsing with deionized water was performed at room temperature for 1 minute, and the substrate was immersed into a catalyst reducing liquid adjusted to 0.8 % (CIRCUPOSIT PB OXIDE CONVERTER 60C, manufactured by Rohm and Haas Electronic Materials K.K.) at 58 °C for 5 minutes, and the catalyst was activated. Rinsing with deionized water was performed at room temperature for 1 minute, and the substrate was immersed into an electroless copper plating liquid (CUPOSIT 71HS, manufactured by Rohm and Haas Electronic Materials K.K.) at 58 °C for 5 minutes, and electroless copper plating was conducted. After rinsing with water, annealing was performed at 120 °C for 30 minutes, and a test substrate where a metal layer was formed on the surface was obtained.

External observation with naked eyes and an adhesion test were conducted with the obtained test substrate. For appearance, if the plating was precipitated on the entire surface of the test substrate, it was evaluated as "excellent", and if the plating precipitation was only partial, an approximate ratio of precipitation was indicated with a percentage.

For the adhesion, one hundred 1-mm squares in length and width were formed on the electroless copper plating layer, and operation to peel off after pressing Cellotape® LP-18 L Pack™ Cellotape (18 mm in width) manufactured by NICHIBAN Co., Ltd. onto these squares was conducted 5 times in total by changing the tape every time, and whether or not the electroless plated layer was peeled off thereafter was observed with naked eyes.

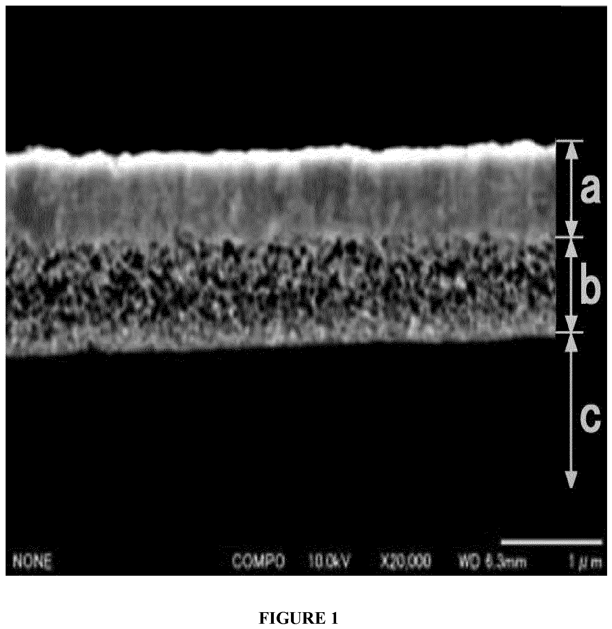

The test substrate where the metal layer was formed was cut, and its cross section was observed with an electronic microscope. A microscope photograph of the cross section is shown in Fig. 1. A layer *a* in Fig. 1 represents a copper plated metal layer, a layer *b* represents a photosensitive film layer, and a layer c represents a polyester film (substrate) layer. According to Fig. 1, fine unevenness occurred on the surface of solidified photosensitive film, and a plated metal layer with unevenness (anchor effect) was observed. Consequently, it appears that high adhesiveness was expressed.

### Comparative Example 1:

Except for not performing the development in the step (c) and the pre-treatment with the alkaline pre-treatment liquid in the step (e), the similar process as Example 1 was conducted. Any metal film was not formed on the surface of the test substrate at all (0 %). Comparative Example 2:

Except for not performing the development in the step (c), the similar process as Example 1 was conducted. Although a metal layer was formed on the surface of the test substrate, the metal layer was peeled off at the adhesion test, and it became ascertained that the adhesion was insufficient.

### Comparative Example 3:

Except for not performing the pre-treatment with the alkaline pre-treatment liquid in the step (e), the similar process as Example 1 was conducted. A metal film was hardly formed on the surface of the test substrate (1 %).

Furthermore, since the plating was not precipitated or the plating was hardly precipitated in Comparative Examples 1 and 3, the adhesion test was not implemented.

**Table 3**

| Step | Example 1 | Comparative Example 1 | Comparative Example 2 | Comparative Example 3 |
|---|---|---|---|---|
| (a) | Implemented | Implemented | Implemented | Implemented |
| (b) | Implemented | Implemented | Implemented | Implemented |
| (c) | Implemented | Not implemented | Not implemented | Implemented |
| (d) | Implemented | Implemented | Implemented | Implemented |
| (e) | Implemented | Not implemented | Implemented | Not implemented |
| (f) | Implemented | Implemented | Implemented | Implemented |
| (g) | Implemented | Implemented | Implemented | Implemented |
| Appearance | Precipitated | Not precipitated (0 %) | Precipitated | Hardly precipitated (1 %) |
| Adhesion | Not peeled off | - | Peeled off | - |

### Comparative Example 4:

As the reactive polymer in the step (a), a commercial acrylic photosensitive resin composition: Hitaloid 7902A (manufactured by Hitachi Chemical Co., Ltd.) was used. The similar operation to that in Example 1 was conducted, but the test substrate was not developed with the alkaline developing fluid in the step (c). No plating was precipitated on the obtained test substrate at all. Since the test substrate was not developed with the alkaline developing fluid, it is believed that the reactive polymer used in Comparative Example 4 hardly contains a carboxyl group or a sulfo group, which is a polar group, within a molecule, and consequently, it was believed that the carboxyl group or the like was not exposed to the surface, and the plating was not precipitated.

### Examples 2 to 4:

Except for changing the concentration of the alkaline pre-treatment fluid to those shown in Table 4, the process was conducted similarly to Example 1, and a test substrate where a metal layer was formed on the surface was obtained.

**Table 4:**

| | Example 1 | Example 2 | Example 3 | Example 4 |
|---|---|---|---|---|
| Concentration of sodium hydroxide (normal (N)) | 1.0 | 0.5 | 0.1 | 2.0 |
| pH of pre-treatment liquid | 12.9 | 12.7 | 12.4 | 13 |
| Appearance | Excellent | Excellent | Excellent | Excellent |
| Adhesion | No peel off | No peel off | No peel off | No peel off |

### Examples 5 to 6 and Comparative Examples 5 to 11:

Except for changing the pre-treatment liquid in the step (e) to the solution shown in Table 5, the similar operation to Example 1 was conducted.

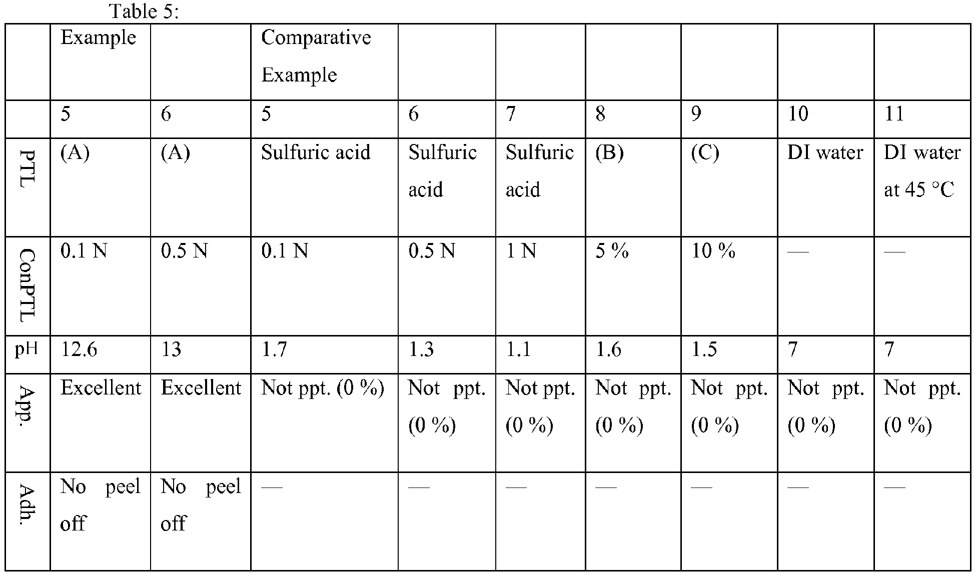

Pre-treatment liquid (A): Alkylate™ metal surface treatment liquid (manufactured by Rohm and Haas Electronic Materials K.K.)
Pre-treatment liquid (B): CIRCUPOSIT™ 3328 Conditioner (manufactured by Rohm and Haas Electronic Materials K.K.)
Pre-treatment liquid (C): CIRCUPOSIT™ Conditioner Neutralizer 3320 (manufactured by Rohm and Haas Electronic Materials K.K.)

### Examples 7 to 9:

Treatment was conducted at 58 °C for 5 minutes using a 2N NaOH solution as the alkali pre-treatment liquid in the step (d), and except for performing the exposure via a mask on the occasion of the exposure in the step (b), the similar operation to that in Example 1 was conducted, provided, however, that the results of the external and adhesion tests were determined not with naked eyes but with metal microscope photographs. Mask width (line/ space), and the results of the external and adhesion tests of the microscope photograph metal layers are shown in Table 6.

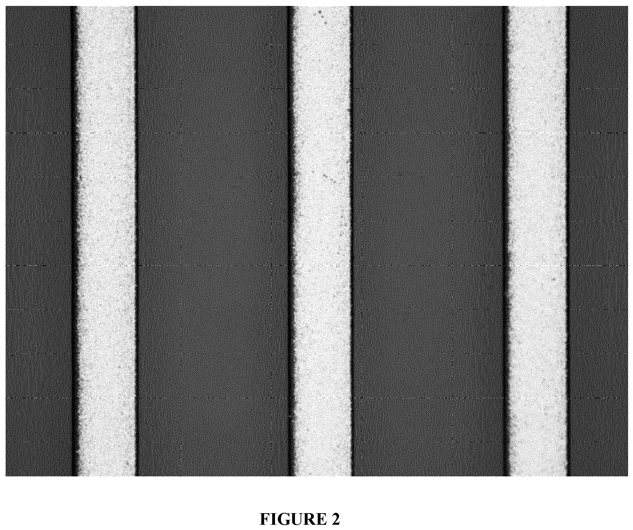

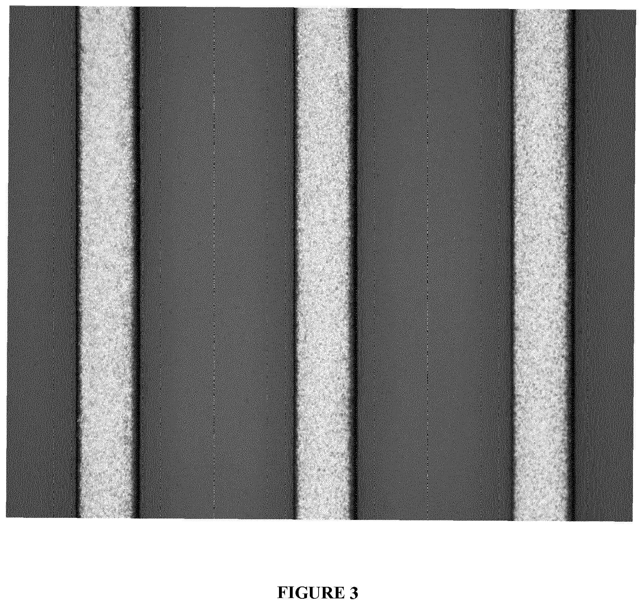

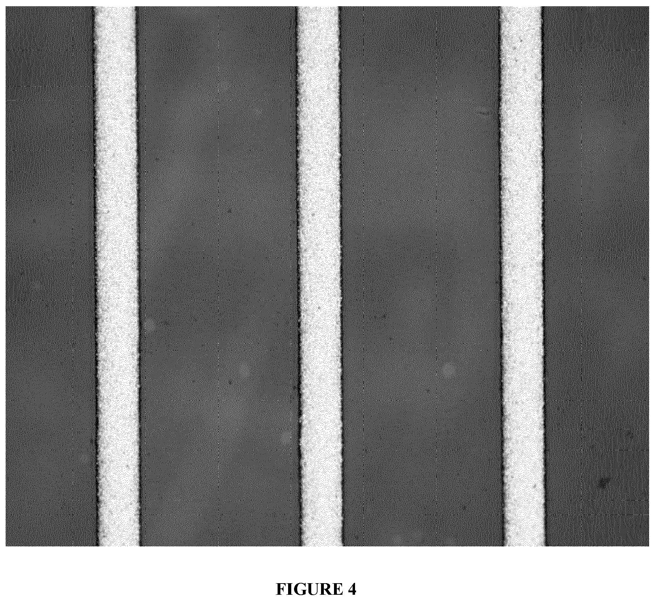

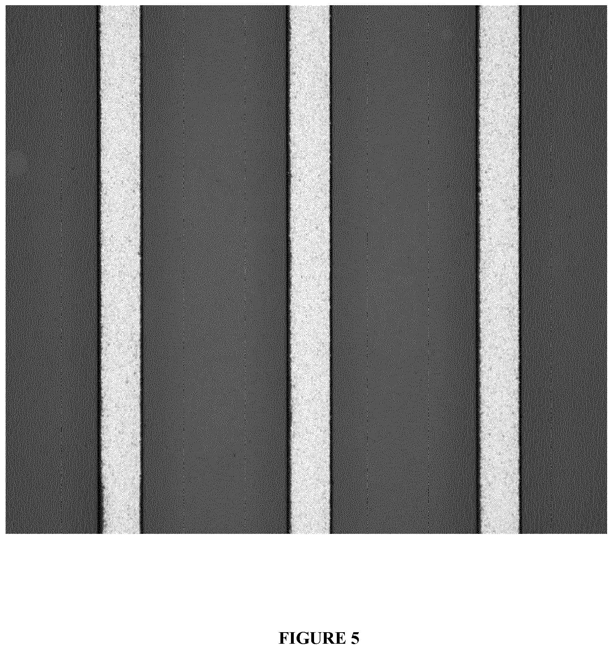

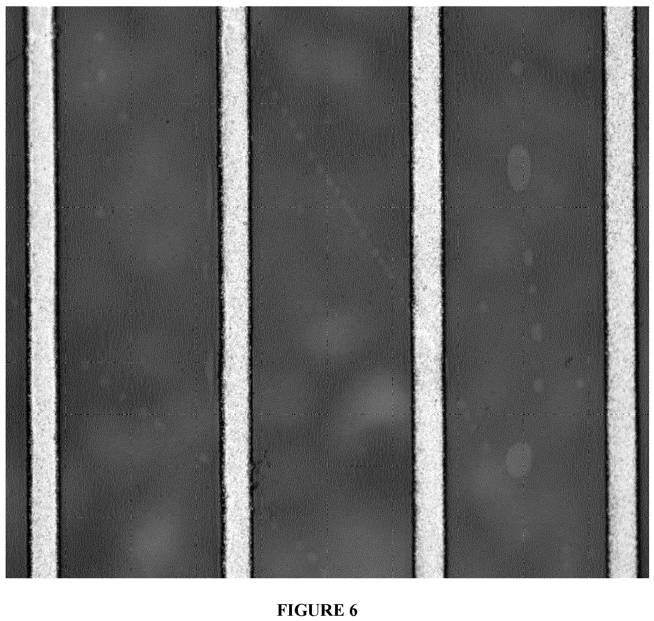

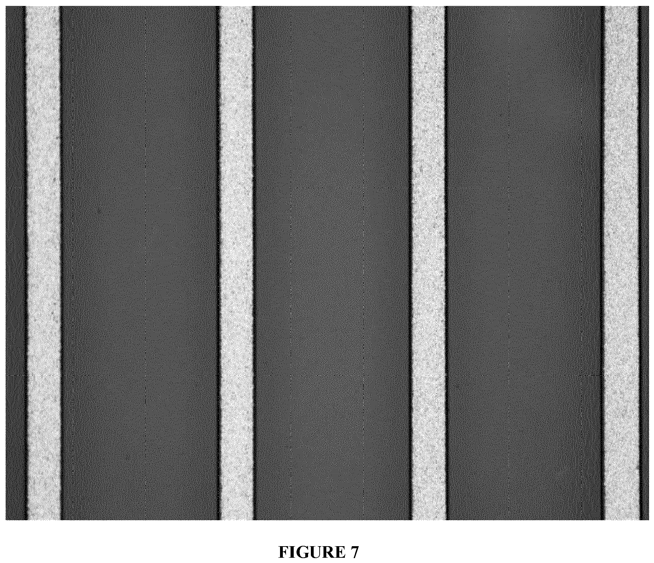

Further, metallic microscope photographs of the metal layer before and after the adhesion test in Example 7 are shown in Fig. 2 and Fig. 3, respectively; metallic microscope photographs of the metal layer before and after the adhesion test in Example 8 are shown in Fig. 4 and Fig. 5, respectively; and metallic microscope photographs of the metal layer before and after the adhesion test in Example 9 are shown in Fig. 6 and Fig. 7, respectively.

**Table 6:**

| | Example 7 | Example 8 | Example 9 |
|---|---|---|---|
| Line/ space (µm) | 70/ 100 | 50/ 100 | 40/ 100 |
| Appearance | Excellent | Excellent | Excellent |
| Adhesion | Not peed off | Not peed off | Not peed off |

### Examples 10 to 12:

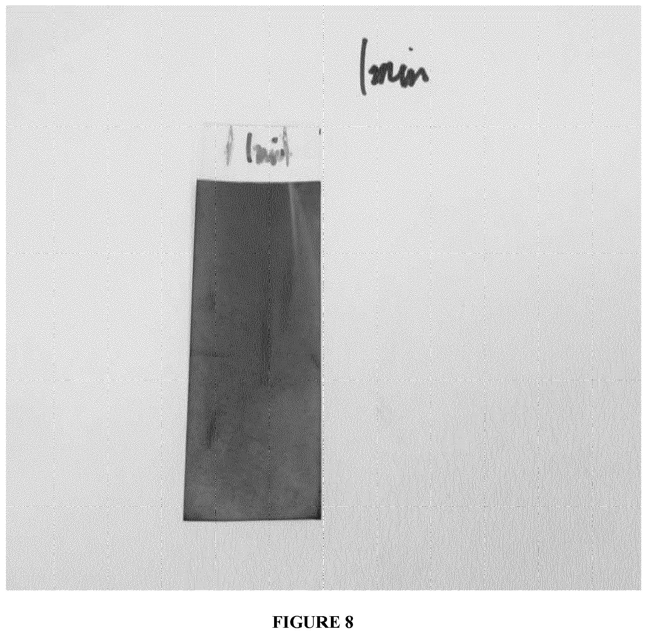

Instead of the electroless copper plating, electroless nickel plating was performed. The process is shown in Table 7. The electroless nickel plating was performed for 1 minute in Example 10; the electroless nickel plating was performed for 3 minutes in Example 11; and the electroless nickel plating was performed for 5 minutes in Example 12. The nickel metal precipitation was excellent in all examples, and the metal film was not peeled off in the adhesion test. A photograph of the nickel metal layer obtained in Example 10 after the adhesion test is shown in Fig. 8. According to Fig. 8, it becomes ascertained that the nickel metal film after the adhesion test was not peeled off at all.

**Table 7:**

| Step | Treatment | Compound in use | Conditions |
|---|---|---|---|
| (a) | Formation of photosensitive film | Photosensitive composition-1 | Spin coating 992 rpm, 30 sec, room temperature |
| | Pre-baking | | 90 °C, 5 min |
| (b) | Exposure | UV | 80 mJ/cm² |
| (c) | Development | 2.38 % TMAH | Room temperature, 1 min |
| | Rinse with water | Deionized water | Room temperature, 2 min |
| (d) | Hard baking | | 120 °C, 30 min |
| (e) | Treatment with alkali pre-treatment liquid | 0.5N NaOH | 45 °C, 5 min |
| | Rinse with water | Deionized water | Room temperature, 2 min |
| (f) | Formation of catalyst | 0.5 % OMNI SHIELD 1573 | 30 °C, 5 min |
| | Rinse with water | Deionized water | Room temperature, 1 min |
| | Catalyst reduction treatment | 0.3 % CIRCPOSIT PB OXIDE CONVERTER 60C | 30 °C, 5 min |
| | Rinse with water | Deionized water | Room temperature, 1 min |
| (g) | Electroless nickel plating | NIPOSIT LT | 59 °C, 1 min, 3 min or 5 min |

## Claims

1. A method for forming a metal layer on a non-conductive substrate, comprising steps of:
(a) applying a photosensitive composition on a non-conductive substrate, and forming a photosensitive film;
(b) exposing at least a portion of the photosensitive film, and solidifying an exposed portion of the photosensitive film;
(c) having the substrate make contact with an alkaline developing fluid, and removing a unexposed portion of the photosensitive film;
(d) thermally heating the substrate;
(e) having the substrate make contact with an alkaline developing fluid, and pre-treating the exposed portion of the photosensitive film with the alkali pre-treatment fluid;
(f) having the substrate make contact with a catalyst solution, and providing the catalyst to the pre-treated exposed portion; and then,
(g) performing electroless metal plating on the exposed portion of the solidified photosensitive film on the substrate.

2. The method according to claim 1, wherein the photosensitive composition comprises a reactive polymer comprising an ethylene unsaturated bond group and at least one type to be selected from a carboxyl group and a sulfo group.

3. The method according to claim 1, wherein the alkaline pre-treatment liquid comprises hydroxide of alkali metal or an organic amine.

4. The method according to claim 1, wherein the catalyst solution comprises metal to be selected from palladium, copper, silver, gold, nickel, platinum, ruthenium, rhodium, osmium and iridium.

5. The method according to claim 1, wherein the metal of the electroless metal plating is selected from copper, nickel, gold, palladium, silver, cobalt, zinc and alloys thereof.
